Europäisches Patentamt

European Patent Office

Office européen des brevets

(11) Publication number: **0 448 720 B1**

(12) **EUROPEAN PATENT SPECIFICATION**

(45) Date of publication of patent specification: **05.07.95**   (51) Int. Cl.⁶: **C23C 14/06**

(21) Application number: **90914417.2**

(22) Date of filing: **28.09.90**

(86) International application number:
**PCT/JP90/01257**

(87) International publication number:
**WO 91/05075 (18.04.91 91/09)**

The file contains technical information submitted
after the application was filed and not included in
this specification

(54) **SURFACE-COATED HARD MEMBER FOR CUTTING AND ABRASION-RESISTANT TOOLS.**

(30) Priority: **29.09.89 JP 2544/90**
**09.05.90 JP 119192/90**
**17.05.90 JP 127660/90**

(43) Date of publication of application:
**02.10.91 Bulletin 91/40**

(45) Publication of the grant of the patent:
**05.07.95 Bulletin 95/27**

(84) Designated Contracting States:
**DE FR GB IT SE**

(56) References cited:
**EP-A- 0 284 854**
**EP-A- 0 352 545**
**JP-A- 6 256 565**
**JP-A-63 255 358**

(73) Proprietor: **SUMITOMO ELECTRIC INDUS-
TRIES, LTD.**
**5-33, Kitahama 4-chome,**
**Chuo-ku**
**Osaka-shi,**
**Osaka 541 (JP)**

(72) Inventor: **OMORI, Naoya Itami Works of**
**Sumitomo Electric**
**Industries, Ltd.**
**1-1, Koyakita 1-chome**
**Itami-shi**
**Hyogo 664 (JP)**
Inventor: **YAMAGATA, Kazuo Itami Works of**
**Sumitomo Electric**
**Industries, Ltd.**
**1-1, Koyakita 1-chome**
**Itami-shi**
**Hyogo 664 (JP)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Inventor: **NOMURA, Toshio Itami Works of**
**Sumitomo Electric**
**Industries, Ltd.**
**1-1, Koyakita 1-chome**
**Itami-shi**
**Hyogo 664 (JP)**
Inventor: **TOBIOKA, Masaaki Itami Works of**
**Sumitomo Electric**
**Industries, Ltd.**
**1-1, Koyakita 1-chome**
**Itami-shi**
**Hyogo 664 (JP)**


(74) Representative: **Allard, Susan Joyce et al**
**BOULT, WADE & TENNANT**
**27 Furnival Street**
**London EC4A 1PO (GB)**

**Description**

Technical Field of The Invention

This invention relates to a surface-coated hard material for cutting tools or wear resistance tools, in which a coating layer is provided on the surface of a base material of a cutting tool or wear resistance tool to improve the wear reistance.

Technical Background

Up to the present time, cutting tools and wear resistance tools have generally been composed of cemented carbides based on tungsten carbide (WC), various cermets based on titanium carbide (TiC), steels such as high-speed steels or hard alloys and ceramics based on silicon carbide and silicon nitride.

In order to improve the wear resistnace of the cutting tools or wear resistance tools, a surface-coated hard material has been developed and has lately been put to practical use, in which one or more layers of carbides, nitrides or carbonitrides of Ti, Hf or Zr or oxide of Al are formed, as hard coating layers, on the surface of the hard material by a PVD method or CVD method. In particular, the hard coating layer formed by the PVD method is capable of improving the wear resistnce without deteriorating the strength of the base material and accordingly, it is suitable for a cutting use requiring a strength, for example, throwaway inserts for drills, end mills, milling cutters, etc.

However, the PVD method is favorably comapred with the CVD method in respect of that the hard coating layer can be formed without deteriorating the strength of the substrate, but in the PVD method, it is difficult to stably form an oxide of Al and accordingly, a hard coating layer consisting of Al oxide formed by the PVD method has not been put to practical use. On the other hand, in the hard coating layer consisting of carbides, nitrides or carbonitrides of Ti, Hf or Zr formed by the present PVD method, the wear resistance cannot be said sufficient and in the high speed cutting, in particular, cutting tools or wear resistance tools thereof have shortened lives because of poor wear resistance.

EP-A-0284854 discloses nitride coatings for tool members, the nitride containing at least two metals, for example Ti and Al in which the concentration of Al is changed within a range of from 5 to 60 weight percent continuously in a step-wise manner (i.e. non-linearly).

Under the situation, the present invention has been made for the purpose of providing a surface-coated hard material for a cutting tool or wear resistance tool having more excellent wear reisistance than that of the prior art with maintaining the substrate strength of the cutting tool or wear resistance tool, in particular, exhibiting excellent wear resistance in the high speed cutting.

Disclosure of The Invention

In order to achieve the above described object, in the surface-coated hard material of the present invention, there is provided (1) a coating layer having such a functional gradient composition that the composition is changed continuously and non-step-wise from TiN of the boundary with the substrate to TiAlN of the outer surface at the opposite side to the substrate on the surface of a cutting tool or wear resistance tool. (2) a hard coating layer having a thickness of 0.5 to 10 $\mu$m and consisting of at least one member selected from the group consisting of carbides, nitrides and carbonitrides of $Zr_{1-x} Al_x$ ($0 \leq x \leq 0.5$) such that the composition ratio of Zr and Al is changed continuously and non-step-wise from Zr of the boundary with the substrate to ZrAl of the outer surface at the opposite side to the substrate on the surface of a cutting tool or wear resistance tool, and (3) a hard coating layer having a thickness of 0.5 to 10 $\mu$m and consisting of at least one member selected from the group consisting of carbides, nitrides and carbonitrides of $Hf_{1-x} Al_x$ ($0 \leq x \leq 0.5$) such that the composition ratio of Hf and Al is changed continuously and non-step-wise from Hf of the boundary with the substrate to HfAl of the outer surface at the opposite side to the substrate on the surface of a cutting tool or wear resistance tool.

That is, the present invention provides a surface-coated hard material for a cutting tool or wear resistance tool characterized by providing a hard coating layer having a thickness of 0.5 to 10 $\mu$m and consisting of at least one member selected from the group consisting of carbides, nitrides and carbonitrides of $M_{1-x} Al_x$ (M represents Ti, Zr or Hf and $0 \leq x \leq 0.5$) such that the composition ratio of M and Al is changed continuously and non-step-wise from M of the boundary with the substrate to MAl of the outer surface at the opposite side to the substrate on the surface of a cutting tool or wear resistance tool.

The hard coating layer can be provided on the whole surface of a cutting tool or wear resistance tool or only the surface of an edge part. Formation of the hard coating layer can be carried out in known manner, but the PVD method such as sputting methods, ion plating methods, etc. is preferable in respect of that the substrate strength can readily be maintained.

In the present invention, the hard coating layer is composed of at least one of carbides, nitrides and carbonitrides of $M_{1-x}$ Al $_x$ ($0 \leq x \leq 0.5$) such that the composition ratio of M and Al is gradient from the boundary with the substrate to the surface opposite to the substrate. That is, the concentration of Al is increased continuously and non-step-wise from the boundary with the substrate to the surface of the hard coating layer in such a manner that $x = 0$ at the boundary with the substrate and $x = 0.5$ at the surface opposite to the substrate in the above described formula.

Since the boundary with the substrate is composed of a carbide, nitride or carbonitride of M, in particular, excellent in bonding strength, the hard coating layer is very excellent in stripping resistance. At the same time, the surface of the hard coating layer is composed of a carbide, nitride or carbonitride of MAl more excellent in wear resistance as well as melt adhesion resistance, so that it is capable of maintaining an excellent cutting property for a long period of time as a cutting tool or wear resistance tool.

Furthermore, it is found that in the surface-coated hard material provided with the above described hard coating layer, as a cutting tool or wear resistance tool, a very small amount of $Al_2O_3$ having a very high hardness at a high temperature is formed in the hard coating layer and accordingly, the tool exhibits a good wear resistance even in the high speed cutting.

The above described functional gradient composition of the hard coating layer is changed continuously and non-step-wise. The layer thickness of the hard coating layer is in the range of 0.5 to 10 $\mu$m, since if less than 0.5 $\mu$m, the wear resistance is hardly improved, while if more than 10 $\mu$m, the breaking resistance is lowered.

In the above described formula, $M_{1-x}$ Al $_x$ , the upper limit of x should be 0.5 since increase of Al in the hard coating layer to exceed $x = 0.5$ results in lowering of the hardness of the whole coating layer.

Examples

The present invention will now be illustrated in greater detail by Examples and Comparative Examples.

Example 1

Using a cutting insert made of a cemented carbdie with a composition of JIS standard P 30 (specifically, WC-20 wt % TiC-10 wt % Co) and a form of JIS SNG 432 as a substrate, the surface thereof was coated with each of coating layers having functional gradient compositions as shown in the following Table 2 by an ion plating method using vacuum arc discharge, as described below.

Namely, the above described cutting insert and Al and Ti as a target were arranged in a film making apparatus, in which the insert was then maintained in an Ar gas atmosphere with a vacuum degree of 1.3Pa ($1 \times 10^{-2}$ torr) rinsed by applying a voltage of -2000 V and heated at 500°C, after which the Ar gas was exhausted. While introducing one or both of $N_2$ gas and $CH_4$ gas at a rate of 300 cc/min into the film making apparatus, the Ti target was evaporated and ionized by vacuum arc discharge to coat the surface of the cutting insert with a carbide, nitride or carbonitride of Ti. Furthermore, various hard coating layers were formed by evaporating and ionizing the Ti target and simultaneously the Al target and controlling the composition ratio of Ti and Al so that the Al concentration was continuously increased non-step-wise and the composition on the surface was a carbide, nitride or carbonitride of TiAl.

For comparison, the surface of a cutting insert with the same composition and same form as described above was coated with the coating layers of carbide, nitride or carbonitride of Ti by an ion plating method using the same film-making apparatus and vacuum arc discharge as described above thereby obtaining samples of surface-coated cutting inserts of the prior art as shown in Table 2. In addition, samples of coated cutting inserts were prepared in which coating layers of carbide of Ti, etc. shown in Table 2 were formed on the surface of the cutting insert with the sane composition and sane form by ordinary CVD method.

Each of the samples of the surface-coated cutting inserts prepared as described above was subjected to a continuous cutting test and intermittent cutting test under conditions as shown in Table 1 to measure the flank wear width of the edge, thus obtaining resuts as shown in Table 3.

Table 1

|  | Continuous Cutting Test | Intermittent Cutting Test |
|---|---|---|
| Workpiece | SCM 435 | SCM 435 |
| Cutting Speed | 220 m/min | 220 m/min |
| Feed | 0.37 mm/rev | 0.30 mm/rev |
| Cutting Depth | 2.0 mm | 1.5 mm |
| Cutting Time | 15 min | 20 min |

Table 2

Sample Forming    Composition and Thickness of Hard Coating layer ($\mu$m)

| Sample | Method | Boundary Layer | Intermediate Layer | Surface Layer |
|---|---|---|---|---|
| 1 | PVD | | $(Ti_{1-x}Al_x)N$ | (4) |
| | | x = 0 $\Rightarrow$ | continuously changed $\Rightarrow$ | x = 0.5 |
| 2 | PVD | | $(Ti_{1-x}Al_x)C_{1-y}N_y$ | (4.5) |
| | | x = 0:y = 0 $\Rightarrow$ | continuously changed $\Rightarrow$ | x = 0.5: y = 0.5 |
| 3 | PVD | | $(Ti_{1-x}Al_x)C_yN_{1-y}$ | (5.5) |
| | | x = 0:y = 0 $\Rightarrow$ | continuously changed $\Rightarrow$ | x = 0.5: y = 0.5 |
| 4 | PVD | | $(Ti_{1-x}Al_x)C_{0.5-y}N_{y+0.5}$ | (5.0) |
| | | x = 0:y = 0 $\Rightarrow$ | continuously changed $\Rightarrow$ | x = 0.5: y = 0.5 |
| 5 | PVD | | $(Ti_{1-x}Al_x)C_{y+0.5}N_{0.5-y}$ | (5.5) |
| | | x = 0:y = 0 $\Rightarrow$ | continuously changed $\Rightarrow$ | x = 0.5: y = 0.5 |
| 6 | PVD | | $(Ti_{1-x}Al_x)C_yN_{1-y}$ | (6.0) |
| | | x = 0:y = 0 $\Rightarrow$ | continuously changed $\Rightarrow$ | x = 0.5: y = 1 |
| 7 | PVD | | $(Ti_{1-x}Al_x)C_{1-y}N_y$ | (5.0) |
| | | x = 0:y = 0 $\Rightarrow$ | continuously changed $\Rightarrow$ | x = 0.5: y = 1 |

Prior Art

| Sample | Method | Boundary Layer | | Intermediate Layer | | Surface Layer | |
|---|---|---|---|---|---|---|---|
| 8 | PVD | TiN | 1 | TiCN | 2 | TiN | 1 |
| 9 | PVD | TiN | 1 | TiCN | 1 | TiN | 2 |
| 10 | PVD | - | | - | | TiN | 4 |
| 11 | CVD | - | | TiC | 3 | TiN | 2 |
| 12 | CVD | TiN | 2 | $Al_2O_3$ | 1 | TiN | 0.5 |

(Note) : Sample Nos. 8, 9, 10 and 12: for comparison

Other Samples: present invention

Table 3

| Sample No. | Flank Wear Width (mm) | |
| --- | --- | --- |
| | Continuous Cutting | Intermittent Cutting |
| 1 | 0.130 | 0.100 |
| 2 | 0.120 | 0.110 |
| 3 | 0.115 | 0.110 |
| 4 | 0.110 | 0.105 |
| 5 | 0.120 | 0.110 |
| 6 | 0.115 | 0.120 |
| 7 | 0.110 | 0.115 |
| 8 | 0.300 | 0.210 |
| 9 | 0.205 | 0.180 |
| 10 | 0.410 | 0.250 |
| 11 | 0.205 | broken |
| 12 | 0.110 | broken |

It is apparent from the above described results that the samples of the coated cutting inserts of the present invention have both an excellent wear resistance and breakage resistance, i.e. more excellent cutting performance than the comaprative samples in both the continuous cutting and intermittent cutting tests.

Example 2

Using a cutting insert made of a cemented carbdie with a composition of JIS standard P 30 (specifically, WC-20 wt % TiC-10 wt % Co) and a form of JIS SNG 432 as a substrate, the surface thereof was coated with each of hard coating layers as shown in the following Table 4 by an ion platingmethod using vacuum arc discharge, as described below, to obtain a sample of surface-coated cutting insert of the present invention.

Namely, the above described cutting insert and Al and Zr as a target were arranged in a film making apparatus, in which the insert was then maintained in an Ar gas atmosphere with a vacuum degree of 1.3Pa $(1 \times 10^{-2}$ torr) rinsed by applying a voltage of -2000 V and heated at 500°C, after which the Ar gas was exhausted. While introducing one or both of $N_2$ gas and $CH_4$ gas at a rate of 300 cc/min into the film making apparatus, the Zr target was evaporated and ionized by vacuum arc discharge to coat the surface of the cutting insert with a carbide, nitride or carbonitride of Zr. Subsequently, various hard coating layers were formed by evaporating and ionizing the Al target and controlling the composition ratio of Zr and Al so that the Al concentration was continuously increased non-step-wise and the composition on the surface was a carbide, nitride or carbonitride of ZrAl.

Table 4

| Sample | Forming Method | Composition and Thickness of Hard Coating layer ($\mu$m) | | |
|---|---|---|---|---|
| | | Boundary Layer | Intermediate Layer | Surface Layer |
| 13 | PVD | | $(Zr_{1-x}Al_x)N$ | (4.0) |
| | | x = 0 | ⇒ continuously changed ⇒ | x = 0.5 |
| 14 | PVD | | $(Zr_{1-x}Al_x)C$ | (4.5) |
| | | x = 0 | ⇒ continuously changed ⇒ | x = 0.5 |
| 15 | PVD | | $(Zr_{1-x}Al_x)CN$ | (4.0) |
| | | x = 0 | ⇒ continuously changed ⇒ | x = 0.5 |
| 16 | PVD | | $(Zr_{1-x}Al_x)C_{1-y}N_y$ | (5.5) |
| | | x = 0:y = 0 | ⇒ continuously changed ⇒ | x = 0.5: y = 0.5 |
| 17 | PVD | | $(Zr_{1-x}Al_x)C_yN_{1-y}$ | (5.0) |
| | | x = 0:y = 0 | ⇒ continuously changed ⇒ | x = 0.5: y = 0.5 |
| 18 | PVD | | $(Zr_{1-x}Al_x)C_{0.5-y}N_{y+0.5}$ | (4.5) |
| | | x = 0:y = 0 | ⇒ continuously changed ⇒ | x = 0.5: y = 0.5 |
| 19 | PVD | | $(Zr_{1-x}Al_x)C_{y+0.5}N_{0.5-y}$ | (6.0) |
| | | x = 0:y = 0 | ⇒ continuously changed ⇒ | x = 0.5: y = 0.5 |
| 20 | PVD | | $(Zr_{1-x}Al_x)C_yN_{1-y}$ | (4.5) |
| | | x = 0:y = 0 | ⇒ continuously changed ⇒ | x = 0.5: y = 1 |
| 21 | PVD | | $(Zr_{1-x}Al_x)C_{1-y}N_y$ | (4.0) |
| | | x = 0:y = 0 | ⇒ continuously changed ⇒ | x = 0.5: y = 1 |

Each of the samples of the surface-coated cutting inserts prepared as described above was subjected to a continuous cutting test and intermittent cutting test under conditions as shown in Table 1 to measure the flank wear width of the edge, thus obtaining resuts as shown in Table 5.

Table 5

| Sample No. | Flank Wear Width (mm) | |
|---|---|---|
| | Continuous Cutting | Intermittent Cutting |
| 13 | 0.128 | 0.101 |
| 14 | 0.118 | 0.114 |
| 15 | 0.125 | 0.105 |
| 16 | 0.108 | 0.098 |
| 17 | 0.112 | 0.100 |
| 18 | 0.105 | 0.098 |
| 19 | 0.110 | 0.105 |
| 20 | 0.115 | 0.110 |
| 21 | 0.105 | 0.102 |

It is apparent from the above described results that of the samples of the surface-coated cutting inserts of the prior art, Sample Nos. 8-10 whose hard coating layers were formed by the PVD method were inferior in wear resistance and Sample Nos. 11 nd 12 whose hard layers were formed by the CVD method exhibited lowering of the breakage resistance due to deterioration of the toughness of the substrate, while Sample Nose 13-21 of the surface-coated cutting inserts according to the present invention showed more excellent wear resistance in both the continuous cutting and intermittent cutting tests and since the hard coating layer was formed by the PVD method, the toughness of the substrate was maintained resulting in more excellent breakage resistance.

Example 3

Using a cutting insert made of a cemented carbdie with a composition of JIS standard P 30 (specifically, WC-20 wt % TiC-10 wt % Co) and a form of JIS SNG 432 as a substrate, the surface thereof was coated with each of hard coating layers as shown in the following Table 6 by an ion platingmethod using vacuum arc discharge, as described below, to obtain Sample Nos. 22 to 30 of the surface-coated cutting inserts of the present invention.

Namely, the above described cutting insert and Al and Hf as a target were arranged in a film making apparatus, in which the insert was then maintained in an Ar gas atmosphere with a vacuum degree of 1.3Pa $(1 \times 10^{-2}$ torr$)$ rinsed by applying a voltage of -2000 V and heated at 500°C, after which the Ar gas was exhausted. While introducing one or both of $N_2$ gas and $CH_4$ gas at a rate of 300 cc/min into the film making apparatus, the Hf target was evaporated and ionized by vacuum arc discharge to coat the surface of the cutting insert with a carbide; nitride or carbonitride of Hf. Subsequently, various hard coating layers were formed by evaporating and ionizing the Al target and controlling the composition ratio of Hf and Al so that the Al concentration was continuously increased non-step-wise and the composition on the surface was a carbide, nitride or carbonitride of HfAl.

Table 6

| Sample | Forming Method | Composition and Thickness of Hard Coating layer ($\mu$m) | | |
|--------|--------|--------|--------|--------|
| | | Boundary Layer | Intermediate Layer | Surface Layer |
| 22 | PVD | | $(Hf_{1-x}Al_x)N$ | (4.0) |
| | | x = 0 ⇒ | continuously changed ⇒ | x = 0.5 |
| 23 | PVD | | $(Hf_{1-x}Al_x)C$ | (4.5) |
| | | x = 0 ⇒ | continuously changed ⇒ | x = 0.5 |
| 24 | PVD | | $(Hf_{1-x}Al_x)CN$ | (5.5) |
| | | x = 0 ⇒ | continuously changed ⇒ | x = 0.5 |
| 25 | PVD | | $(Hf_{1-x}Al_x)C_{1-y}N_y$ | (5.0) |
| | | x = 0:y = 0 ⇒ | continuously changed ⇒ | x = 0.5: y = 0.5 |
| 26 | PVD | | $(Hf_{1-x}Al_x)C_yN_{1-y}$ | (4.5) |
| | | x = 0:y = 0 ⇒ | continuously changed ⇒ | x = 0.5: y = 0.5 |
| 27 | PVD | | $(Hf_{1-x}Al_x)C_{0.5-y}N_{y+0.5}$ | (5.5) |
| | | x = 0:y = 0 ⇒ | continuously changed ⇒ | x = 0.5: y = 0.5 |
| 28 | PVD | | $(Hf_{1-x}Al_x)C_{y+0.5}N_{0.5-y}$ | (6.0) |
| | | x = 0:y = 0 ⇒ | continuously changed ⇒ | x = 0.5: y = 0.5 |
| 29 | PVD | | $(Hf_{1-x}Al_x)C_yN_{1-y}$ | (5.0) |
| | | x = 0:y = 0 ⇒ | continuously changed ⇒ | x = 0.5: y = 1 |
| 30 | PVD | | $(Hf_{1-x}Al_x)C_{1-y}N_y$ | (4.0) |
| | | x = 0:y = 0 ⇒ | continuously changed ⇒ | x = 0.5  y = 1 |

Each of the samples of the surface-coated cutting inserts prepared as described above was subjected to a continuous cutting test and intermittent cutting test under conditions as shown in Table 1 to measure the flank wear width of the edge, thus obtaining resuts as shown in Table 7.

9

# EP 0 448 720 B1

Table 7

| Sample No. | Flank Wear Width (mm) | |
|---|---|---|
| | Continuous Cutting | Intermittent Cutting |
| 22 | 0.131 | 0.095 |
| 23 | 0.129 | 0.092 |
| 24 | 0.125 | 0.090 |
| 25 | 0.120 | 0.092 |
| 26 | 0.122 | 0.090 |
| 27 | 0.118 | 0.085 |
| 28 | 0.120 | 0.090 |
| 29 | 0.117 | 0.085 |
| 30 | 0.119 | 0.087 |

It is apparent from the above described results that of the samples of the surface-coated cutting inserts of the prior art, Sample Nos. 8-10 whose hard coating layers were formed by the PVD method were inferior in wear resistance and Sample Nos. 11 nd 12 whose hard layers were formed by the CVD method exhibited lowering of the breakage resistance due to deterioration of the toughness of the substrate, while Sample Nos. 22-30 of the surface-coated cutting inserts according to the present invention showed more excellent wear resistance in both the continuous cutting and intermittent cutting tests and since the hard coating layer was formed by the PVD method, the toughness of the substrate was maintained resulting in more excellent breakage resistance.

Utility and Possibility

According to the present invention, there can be provided a surface-coated hard material for a cutting tool or wear resistance tool having more excellent wear reisistance than that of the prior art with maintaining the substrate strength of the cutting tool or wear resistance tool, in particular, being capable of maintaining good cutting performances, as a cutting tool or wear resistance tool, for a long period of time even in the high speed cutting.

## Claims

1. A surface-coated hard material for a cutting tool or wear resistance tool characterized by providing a hard coating layer having a thickness of 0.5 to 10 $\mu$ and consisting of at least one member selected from the group consisting of carbides, nitrides and carbonitrides of $M_{1-x} Al_x$ (M represents Ti, Zr or Hf and $0 \leqq x \leqq 0.5$) such that the composition ratio of M and Al is changed continuously from M of the boundary with the substrate to MAl of the outer surface at the opposite side to the substrate on the surface of a cutting tool or wear resistance tool, provided that the continuous composition change is non-step-wise.

2. A surface-coated hard material as claimed in claim 1 which is applied to the whole surface of a cutting tool or wear resistance tool.

3. A surface-coated hard material as claimed in claim 1 which is applied to an edge only of a cutting tool or wear resistance tool.

## Patentansprüche

1. Oberflächenbeschichteter Hartwerkstoff für ein Schneidwerkzeug oder ein verschleißfestes Werkzeug, dadurch gekennzeichnet, daß die Oberfläche eines Schneidwerkzeugs oder eines verschleißfesten Werkzeugs mit einer harten Beschichtung mit einer Dicke von 0,5 bis 10 $\mu$m versehen ist, die aus mindestens einer aus der aus Carbiden, Nitriden und Carbonitriden von $M_{1-x} Al_x$ (M bedeutet Ti, Zr oder Hf und $0 \leqq x \leqq 0,5$) bestehenden Gruppe ausgewählten Substanz besteht, und zwar so, daß das Zusammensetzungsverhältnis von M und Al sich kontinuierlich von M an der Grenze mit dem Substrat zu MAl an der äußeren Oberfläche auf der dem Substrat gegenüberliegenden Seite verändert,

10

vorausgesetzt, die kontinuierliche Veränderung in der Zusammensetzung geht nicht schrittweise vor sich.

**2.** Oberflächenbeschichteter Hartwerkstoff nach Anspruch 1, der auf die gesamte Oberfläche eines Schneidwerkzeugs oder eines verschleißfesten Werkzeugs aufgebracht wird.

**3.** Oberflächenbeschichteter Hartwerkstoff nach Anspruch 1, der nur auf die Kante eines Schneidwerkzeugs oder eines verschleißfeste Werkzeugs aufgebracht wird.

**Revendications**

**1.** Matériau dur revêtu superficiellement pour un outil de coupe ou un outil résistant à l'usure, caractérisé en ce qu'il fournit une couche dure de revêtement ayant une épaisseur de 0,5 à 10 $\mu$m et constituée d'au moins un élément choisi dans l'ensemble constitué par les carbures, les nitrures et les carbonitrures de $M_{1-x}Al_x$ (M représente Ti, Zr ou Hf, et $0 \leq x \leq 0,5$), d'une manière telle que le rapport de M et Al dans la composition est modifié de manière continue, de M à la limite avec le substrat à MAl de la surface extérieure du côté opposé au substrat, sur la surface d'un outil de coupe ou d'un outil résistant à l'usure, avec la condition que la modification continue de la composition se fasse sans paliers.

**2.** Matériau dur revêtu superficiellement tel que revendiqué dans la revendication 1, qu'on applique sur l'ensemble de la surface d'un outil de coupe ou d'un outil résistant à l'usure.

**3.** Matériau dur revêtu superficiellement tel que revendiqué dans la revendication 1, qu'on applique seulement sur une arête d'un outil de coupe ou d'un outil résistant à l'usure.

11